# EUROPEAN PATENT APPLICATION

(11) **EP 4 746 039 A1**
(43) Date of publication of application: **20.05.2026**
(21) Application number: 24839593.1
(22) Date of filing: 02.07.2024
(51) Int. Cl.: H01L 23/12, H05K 3/00, H05K 3/46

(54) **CARRIER-ATTACHED METAL FOIL, LAMINATE, AND METHOD FOR MANUFACTURING WIRING BOARD**

(30) Priority: 11.07.2023 JP 2023113909
(71) Applicant: Mitsui Kinzoku Company, Limited, Tokyo 141-8584 (JP)
(72) Inventor: NAKAMURA, Toshimi, Ageo-shi, Saitama 362-0021 (JP); KITABATAKE, Yukiko, Ageo-shi, Saitama 362-0021 (JP); MATSUURA, Yoshinori, Ageo-shi, Saitama 362-0021 (JP)
(74) Representative: Potter Clarkson
(86) International application number: PCT/JP2024/023945
(87) International publication number: WO 2025/013701

(57) **Abstract**

There is provided a carrier-attached metal foil that enables accurate positional alignment of a laminate after mold forming and therefore allows appropriate downsizing of the laminate. The carrier-attached metal foil includes a carrier having a first surface and a second surface, a release layer provided on the first surface, and a metal layer provided on the release layer, and has at least one alignment mark on or in the vicinity of the second surface of the carrier.

## Description

### TECHNICAL FIELD

The present invention relates to a carrier-attached metal foil, a laminate, and a method for manufacturing a wiring board.

### BACKGROUND ART

In recent years, multilayering of printed wiring boards has become widespread to increase the mounting density of the printed wiring boards for size reduction. Such multilayer printed wiring boards have been in use in many portable electronic apparatuses to reduce weight and size. These multilayer printed wiring boards have been required to have further reductions in the thicknesses of interlayer insulating layers and to still further weight reductions as wiring boards.

As a technique for satisfying such requirements, a method for manufacturing a multilayer printed wiring board using a coreless build-up method has been adopted. The coreless build-up method is a method of alternately laminating (building up) insulating layers and wiring layers for multilayering, without using a so-called core substrate. For the coreless build-up method, using a carrier-attached copper foil has been proposed to enable easy release of a support and a multilayer printed wiring board from each other. For example, Patent Literature 1 (JP2005-101137A) discloses a method for manufacturing a package substrate for semiconductor device mounting, the method including affixing an insulating resin layer to the carrier surface of a carrier-attached copper foil to form a support, forming a first wiring conductor on the superthin copper layer side of the carrier-attached copper foil by steps such as photoresist processing, pattern electrolytic copper plating, and resist removal, then forming build-up wiring layers, releasing the carrier-attached supporting substrate, and removing the superthin copper layer.

For the fining of an embedded circuit as shown in Patent Literature 1, a carrier-attached copper foil in which the thickness of a superthin copper layer is 1 µm or less is desired. Therefore, it has been proposed to use a vapor phase method, such as sputtering, to form a superthin copper layer and achieve a reduction in the thickness of the superthin copper layer. For example, Patent Literature 2 (WO2017/150283) discloses a carrier-attached copper foil in which a release layer, an antireflection layer, and a superthin copper layer are formed on a carrier such as glass or ceramic by sputtering. Patent Literature 3 (WO2017/150284) discloses a carrier-attached copper foil in which intermediate layers (for example, an adhesion metal layer and a release-assisting layer), a release layer, and a superthin copper layer (for example, a film thickness of 300 nm) are formed on a carrier such as glass or ceramic by sputtering. Patent Literatures 2 and 3 also teach that intermediate layers composed of predetermined metals are interposed, thus providing excellent stability of the mechanical release strength of the carrier, and that the antireflection layer exhibits a desirable dark color, thus improving visibility in image inspection (for example, automatic image inspection (AOI)).

Especially, with still further size reduction and power saving of electronic devices, there is a growing need for the high integration and thinning of semiconductor chips and printed wiring boards. As next-generation packaging techniques for satisfying such a need, the adoption of fan-out wafer level packaging (FO-WLP) and panel level packaging (PLP) has been studied in recent years. The adoption of the coreless build-up method has also been studied for FO-WLP and PLP. One such method is a method referred to as a redistribution layer-first (RDL-first) method in which a wiring layer and, if necessary, a build-up wiring layer are formed on a coreless support surface, and, if necessary, the support is released, followed by mounting of chips. For example, Patent Literature 4 (JP2015-35551A) discloses a method for manufacturing a semiconductor apparatus, the method including forming a metal release layer on the main surface of a support composed of glass or a silicon wafer, forming an insulating resin layer on the metal release layer, forming a redistribution layer including build-up layers on the insulating resin layer, mounting and sealing semiconductor integrated circuits on the redistribution layer, exposing the release layer by the removal of the support, exposing secondary mounting pads by the removal of the release layer, and forming solder bumps on the surfaces of the secondary mounting pads, and performing secondary mounting.

Meanwhile, in the case where a redistribution layer is formed on a carrier-attached metal foil by a build-up method or the like, it has been proposed, from the viewpoint of suppressing yield reduction and the like, to carry out positional alignment based on an alignment mark prior to exposure. For example, Patent Literature 5 (JP7142774B) discloses a carrier-attached metal foil having at least two positioning regions constituting an alignment mark used for positional alignment at the time of wiring formation accompanied by exposure and development. According to Patent Literature 5, by providing a processed portion constituting the alignment mark in the carrier itself, both exposure for a rough circuit and exposure for a fine circuit at the time of wiring formation can be carried out based on the same alignment mark.

### CITATION LIST

### PATENT LITERATURE

Patent Literature 1: JP2005-101137A
Patent Literature 2: WO2017/150283
Patent Literature 3: WO2017/150284
Patent Literature 4: JP2015-35551A
Patent Literature 5: JP7142774B

### SUMMARY OF INVENTION

As a technology that meets the demand for recent high density mounting, there is a method called PoP (Package on Package), in which a plurality of IC packages are stacked and mounted on a substrate. According to PoP mounting, the degree of integration can be improved as compared with a conventional mounting method in which IC packages are arranged two-dimensionally on a substrate. In the case of adopting PoP mounting in the manufacture of a wiring board using a carrier-attached metal foil, for example, after chips and the like are mounted on a wiring layer formed on a metal layer of the carrier-attached metal foil and mold forming is carried out, a redistribution layer is formed on a resin-containing layer such as a mold resin layer, and further chips and the like are mounted on this redistribution layer. Here, in the process of forming the redistribution layer, since it is required to preliminarily adjust the substrate to a size corresponding to the standard of the apparatus, carrying out downsizing of the laminate after mold forming may become necessary. However, conventional carrier-attached metal foils cannot be said to sufficiently cope with such downsizing of the laminate after mold forming.

The present inventors have now found that, in a carrier-attached metal foil, by providing an alignment mark on a surface on the opposite side to the metal layer of the carrier, positional alignment of the laminate after mold forming can be accurately carried out, and therefore, downsizing of the laminate can be appropriately carried out.

Accordingly, an object of the present invention is to provide a carrier-attached metal foil that enables accurate positional alignment of a laminate after mold forming and therefore allows appropriate downsizing of the laminate.

The present invention provides the following aspects:

### [Aspect 1]

A carrier-attached metal foil comprising a carrier having a first surface and a second surface, a release layer provided on the first surface, and a metal layer provided on the release layer,
wherein the carrier-attached metal foil has at least one alignment mark on or in a vicinity of the second surface of the carrier.

### [Aspect 2]

The carrier-attached metal foil according to aspect 1, wherein the alignment mark has a shape capable of acquiring positional information in a horizontal direction and a rotational direction on the second surface of the carrier.

### [Aspect 3]

The carrier-attached metal foil according to aspect 1 or 2, wherein at least one of the alignment marks is positioned at a geometric center on the second surface of the carrier.

### [Aspect 4]

The carrier-attached metal foil according to any one of aspects 1 to 3, wherein the alignment mark has at least one shape selected from the group consisting of a cross, a polygon, a star-shaped polygon, a circle, an ellipse, a character, and a symbol.

### [Aspect 5]

The carrier-attached metal foil according to any one of aspects 1 to 4, wherein the carrier is composed of at least one selected from the group consisting of glass, silicon, ceramic, resin, and metal.

### [Aspect 6]

The carrier-attached metal foil according to any one of aspects 1 to 5, wherein the alignment mark is formed by at least one selected from the group consisting of laser printing, laser engraving, gravure printing, flexographic printing, ink jet printing, silk printing, laser inner marking, and drilling.

### [Aspect 7]

A laminate comprising the carrier-attached metal foil according to any one of aspects 1 to 6 and a resin-containing layer provided on the metal layer.

### [Aspect 8]

The laminate according to aspect 7, wherein the resin-containing layer covers at least a part of a side surface of the carrier-attached metal foil, thereby having an extending portion extending outward beyond an end surface of the carrier.

### [Aspect 9]

The laminate according to aspect 7 or 8, wherein the resin-containing layer embeds an entirety of the carrier-attached metal foil except for the second surface.

### [Aspect 10]

The laminate according to any one of aspects 7 to 9, wherein the resin-containing layer comprises an insulating resin.

### [Aspect 11]

A method for manufacturing a wiring board, comprising the steps of:
providing the carrier-attached metal foil according to any one of aspects 1 to 6;
forming a resin-containing layer on the metal layer of the carrier-attached metal foil so that the resin-containing layer covers at least a part of a side surface of the carrier-attached metal foil, thereby having an extending portion extending outward beyond an end surface of the carrier; and
carrying out positioning based on the alignment mark provided on the second surface of the carrier and cutting off at least a part of the extending portion.

### [Aspect 12]

The method for manufacturing a wiring board according to aspect 11, wherein cutting-off of the extending portion is carried out so that, when the carrier-attached metal foil with the resin-containing layer formed thereon is seen in a plan view, an extending width of a portion of the resin-containing layer extending from an end surface of the carrier is 1.0 mm or less.

### [Aspect 13]

The method for manufacturing a wiring board according to aspect 11 or 12, further comprising a step of forming a redistribution layer on a surface of the resin-containing layer after cutting off at least a part of the extending portion.

### [Aspect 14]

The method for manufacturing a wiring board according to aspect 13, further comprising a step of polishing a surface of the resin-containing layer before forming the redistribution layer.

### [Aspect 15]

The method for manufacturing a wiring board according to any one of aspects 11 to 14, wherein the resin-containing layer comprises a wiring layer and an insulating layer.

### [Aspect 16]

A cutting apparatus for downsizing the laminate according to any one of aspects 7 to 10, the cutting apparatus comprising:
a fixing unit that fixes the laminate;
an identifying unit that recognizes the alignment mark from a second surface side of the carrier with respect to the laminate fixed by the fixing unit to specify positional information of the laminate; and
a cutting-off unit that cuts off a side surface of the laminate whose positional information has been specified by the identifying unit.

### BRIEF DESCRIPTION OF DRAWINGS

Figure 1 is a schematic cross-sectional view illustrating one aspect of the carrier-attached metal foil of the present invention.
Figure 2A is a schematic bottom view of the carrier-attached metal foil shown in Figure 1 as seen from the second surface side of the carrier, illustrating an example of the shape of an alignment mark.
Figure 2B illustrates another example of the shape of an alignment mark.
Figure 2C illustrates yet another example of the shape of an alignment mark.
Figure 3A is a process flow chart illustrating an example of downsizing of a laminate, shown as a schematic bottom view of a laminate after mold forming as seen from the second surface side of the carrier.
Figure 3B is a process flow chart illustrating another example of downsizing of a laminate, shown as a schematic bottom view of an offset-molded laminate as seen from the second surface side of the carrier.
Figure 4 is a schematic cross-sectional view illustrating one aspect of the laminate of the present invention.
Figure 5 is a process flow chart illustrating an example of a method for manufacturing a laminate using a carrier-attached metal foil, shown as schematic cross-sectional views, corresponding to the initial steps ((i) to (iii)).
Figure 6 is a process flow chart illustrating an example of a method for manufacturing a laminate using a carrier-attached metal foil, shown as schematic cross-sectional views, corresponding to the later steps ((iv) and (v)) following the steps shown in Figure 5.
Figure 7 is a process flow chart illustrating the preparation of a laminate using a mold for full molding, shown as schematic cross-sectional views.
Figure 8 is a process flow chart illustrating the preparation of a laminate using a mold for flange molding, shown as schematic cross-sectional views.
Figure 9 is a process flow chart illustrating an example of the method for manufacturing a wiring board of the present invention, shown as schematic cross-sectional views.

### DESCRIPTION OF EMBODIMENTS

### Carrier-Attached Metal Foil

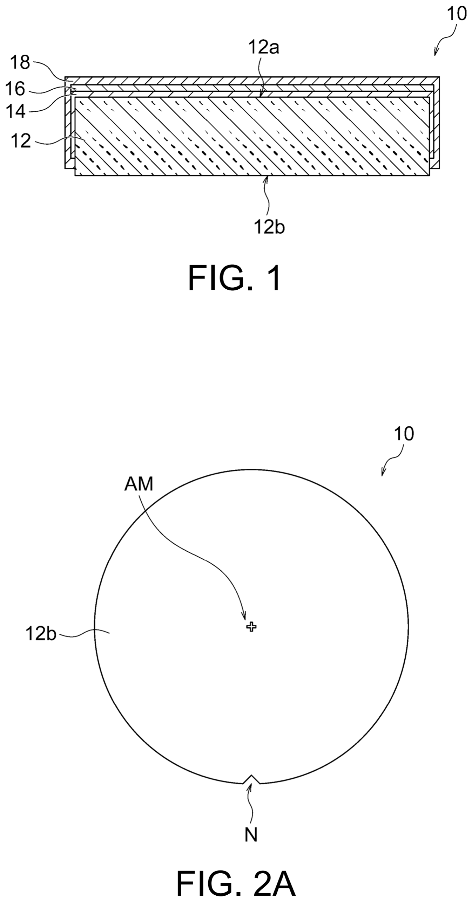

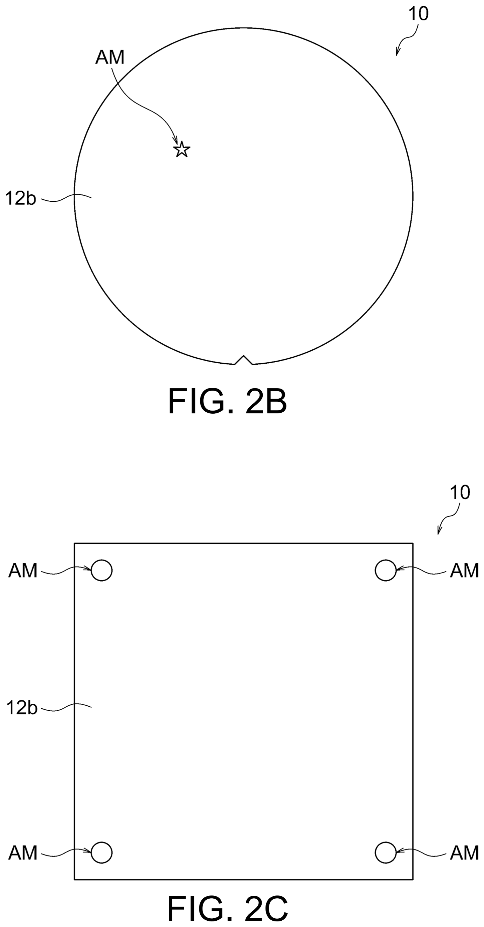

An example of the carrier-attached metal foil of the present invention is schematically illustrated in Figures 1 and 2. As shown in Figure 1, a carrier-attached metal foil 10 includes a carrier 12, a release layer 16, and a metal layer 18 in this order. The carrier 12 has a first surface 12a and a second surface 12b. The release layer 16 is provided on the first surface 12a of the carrier. The metal layer 18 is provided on the release layer 16. Optionally, the carrier-attached metal foil 10 may further include an intermediate layer 14 between the carrier 12 and the release layer 16. Each of the intermediate layer 14, the release layer 16, and the metal layer 18 may be a single layer composed of one layer or a multilayer composed of two or more layers. As shown in Figures 2A to 2C, the carrier-attached metal foil 10 has at least one alignment mark AM on or in the vicinity of the second surface 12b of the carrier (hereinafter sometimes simply referred to as "the second surface 12b of the carrier" or "the second surface 12b"). As described above, in the carrier-attached metal foil 10, by providing the alignment mark AM on the surface on the opposite side to the metal layer 18 of the carrier 12 (that is, the second surface 12b), positional alignment of the laminate after mold forming can be accurately carried out, and therefore, downsizing of the laminate can be appropriately carried out.

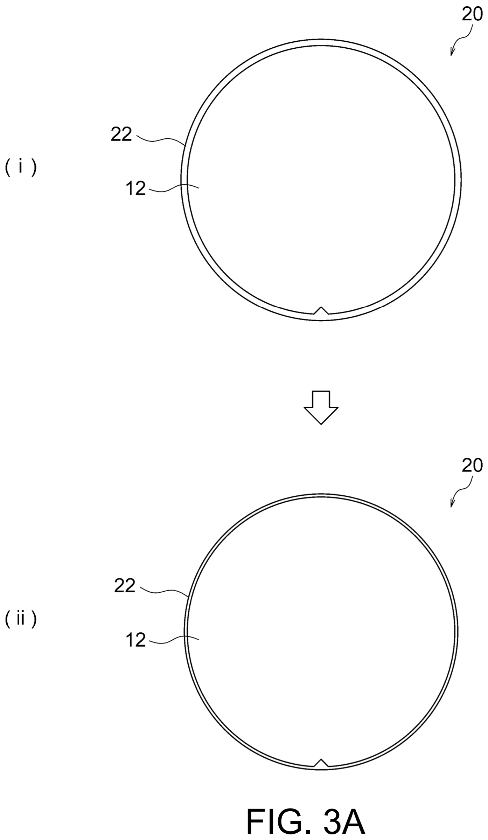

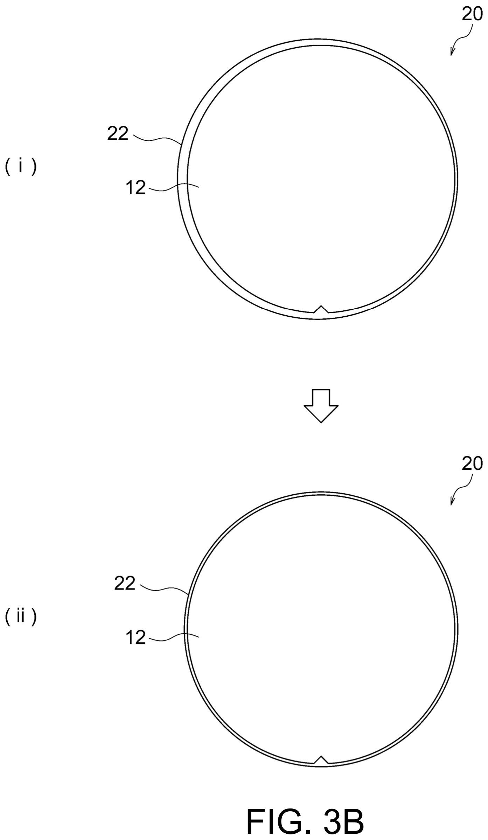

As described above, in the manufacture of a wiring board using a carrier-attached metal foil, formation of a redistribution layer on a resin-containing layer such as a mold resin layer may be carried out. Then, in the process of forming the redistribution layer, since it is required to preliminarily adjust the substrate to a size corresponding to the standard of the apparatus, carrying out downsizing of the laminate after mold forming may become necessary. Specifically, as a result of mold forming (for example, full mold forming), the resin-containing layer may extend from the end surface of the carrier, causing the size of the laminate including the resin-containing layer to be larger than the original carrier-attached metal foil 10, and therefore, it may become necessary to cut off the extending portion of the resin-containing layer. Here, an example of downsizing of a laminate after mold forming is illustrated in Figures 3A and 3B. Figure 3A and Figure 3B are schematic bottom views of a laminate 20 including a resin-containing layer 22 as seen from the second surface 12b side of the carrier. In this regard, as shown in Figure 3A(i), it is typical to carry out mold forming so that the resin-containing layer 22 extends uniformly from the end surface (outer edge) of the carrier 12; however, as shown in Figure 3B(i), unintentional positional misalignment (offset molding) may occur during mold forming, and the resin-containing layer 22 may extend non-uniformly from the end surface of the carrier 12. In either case, in order to proceed to the step of forming the redistribution layer, as shown in Figure 3A(ii) and Figure 3B(ii), the resin-containing layer 22 needs to be cut off so that the length of the portion extending from the end surface of the carrier 12 is equal to or less than a predetermined value, thereby downsizing the laminate 20. Thus, in order to appropriately carry out downsizing of the laminate 20 regardless of the accuracy of mold forming, it is desirable to carry out positional alignment of the laminate 20 using an alignment mark.

In this regard, conventional carrier-attached metal foils, such as one disclosed in Patent Literature 5, were not designed to cope with positional alignment of a laminate after mold forming. That is, conventional carrier-attached metal foils focus on using alignment marks for positional alignment carried out prior to exposure at the time of wiring formation, and have the alignment marks provided on the surface on the metal layer side of the carrier. Therefore, when the metal layer side or the like of the carrier-attached metal foil is embedded in a resin-containing layer by mold forming, it becomes no longer possible to identify the alignment marks. In contrast, in the carrier-attached metal foil 10 of the present invention, since the alignment mark AM is provided on the surface on the opposite side to the metal layer 18 of the carrier 12 (that is, the second surface 12b), even in the case where the entire carrier-attached metal foil 10 other than the second surface 12b is embedded in a resin-containing layer, the alignment mark AM can be identified from the second surface 12b side. Accordingly, positional alignment of the laminate after mold forming can be accurately carried out based on the alignment mark AM, and downsizing of the laminate can be appropriately carried out.

The number of alignment marks AM provided on the second surface 12b of the carrier is at least one. However, the number and shape of the alignment marks AM are not particularly limited, and may be determined as appropriate depending on the specifications of a known position detection apparatus (more specifically, the algorithm of a position detection program). Even if there is only one alignment mark AM, it is preferable that the number of alignment marks AM is one in the case of a position detection apparatus capable of acquiring positional information in a horizontal direction and a rotational direction on the second surface 12b. On the other hand, in the case of a position detection apparatus that reads a plurality of alignment marks AM and integrates their information to acquire positional information in a horizontal direction and a rotational direction on the second surface 12b, it is preferable that the number of alignment marks AM is two or more. The upper limit of the number of alignment marks AM provided on the second surface 12b of the carrier is not particularly limited; typically, it is 200 or less, more typically 100 or less, and further typically 50 or less. In any case, regardless of the shape and number of the alignment marks AM, if they match the shape and number of alignment marks of a pattern previously registered in the position detection apparatus, the center position and angle of the carrier can be detected, and positional alignment can be accurately carried out. It is preferable that the alignment mark AM has a simple shape (for example, a cross, a polygon, a star-shaped polygon, a circle, or an ellipse, as described later) and the number thereof is one, and in this way, formation of the alignment mark is simple while positional alignment of the laminate after mold forming can still be accurately carried out. It is preferable that the carrier-attached metal foil 10 has no alignment mark on the first surface 12a side of the carrier, whereby the entire surface of the metal layer 18 can be utilized for wiring formation.

It is preferable that at least one of the alignment marks AM is positioned at the geometric center (centroid) on the second surface 12b of the carrier, as shown in Figure 2A. In this way, as compared with the case where the alignment mark AM is positioned at a random location (a location other than the geometric center) on the second surface 12b of the carrier, as shown in Figure 2B, the position detection apparatus can more easily find the position of the alignment mark AM, and the process can proceed to positional alignment even more smoothly.

The alignment mark AM may basically have any shape, but typically has a shape that enables acquisition of positional information in a horizontal direction and a rotational direction on the second surface 12b of the carrier, and preferably has a shape that facilitates acquisition of positional information in a horizontal direction and a rotational direction. By having such a shape, it becomes possible to more reliably calculate the amount of positional misalignment in the horizontal direction (xy direction) and the rotational direction (θ direction) from the original position during positional alignment, and positional alignment can be even more accurately carried out.

Preferred examples of the shape of the alignment mark AM include, but are not limited to, a cross (see Figure 2A), a polygon, a star-shaped polygon (see Figure 2B), a circle (see Figure 2C), an ellipse, a character, a symbol, and a combination thereof. Positioning is generally carried out by contour search (geometric shape search), which includes detecting edges from the contour of the alignment mark and specifying the position of the center point of the alignment mark, and when the alignment mark AM has the above shape, it is possible to reduce errors in specifying the center point and to carry out positional alignment with even higher accuracy.

The alignment mark AM is provided on or in the vicinity of the second surface 12b of the carrier. In the present invention, the vicinity of the second surface 12b means a position from which the alignment mark can be optically read from the second surface 12b side of the carrier (for example, a position where the alignment mark can be imaged by an imaging means such as a CCD camera). The alignment mark AM, as described above, only needs to be capable of being imaged by an imaging means from the second surface 12b side of the carrier and of being recognized in terms of its shape by image processing, and the formation method therefor is not particularly limited. For example, the alignment mark AM is preferably formed by laser printing, laser engraving, gravure printing, flexographic printing, ink jet printing, silk printing, laser inner marking, drilling, or a combination thereof, and more preferably by laser engraving, laser inner marking, or a combination thereof. For example, in the case where the carrier 12 is composed of a material having optical transparency, and in the case where the alignment mark is formed by laser inner marking from the second surface 12b side of the carrier, the alignment mark thus formed inside the carrier falls within the scope of the alignment mark AM provided in the vicinity of the second surface 12b of the carrier. In particular, the alignment mark AM formed by the above-mentioned various printing and/or laser methods is preferable because it can effectively suppress a reduction in the strength of the carrier 12.

The carrier 12 is preferably composed of glass, silicon, ceramic, resin, metal, or a combination thereof, more preferably of glass, silicon, or ceramic, and further preferably of glass or silicon. The carrier 12 is also preferably composed of a material having optical transparency (for example, glass), as described above. The carrier 12 composed of silicon may be any carrier as long as it contains Si as an element, and a SiO₂ substrate, a SiN substrate, a Si single crystal substrate, and a Si polycrystalline substrate, or the like can be applied. According to a preferred aspect of the present invention, the carrier 12 has a disk shape with a diameter of 100 mm or more, and more preferably a disk shape with a diameter of 200 mm or more and 450 mm or less. The carrier 12 (for example, a Si single crystal substrate) may have a notch N, as shown in Figure 2A, or an orientation flat in order to indicate a reference point of the crystal orientation. In general, when the diameter of the carrier 12 is 200 mm or less, an orientation flat is formed, and when it is 200 mm or more, a notch is formed. According to another preferred aspect of the present invention, the carrier 12 has a rectangular shape with a short side of 100 mm or more, and more preferably a short side of 150 mm or more and 650 mm or less. The rectangular carrier 12 may have a roll shape with its long side sufficiently longer than its short side, and preferably has a long side of 200 mm or more and 650 mm or less.

The form of the carrier 12 may be any one of a sheet, a film, and a plate. The carrier 12 may be a laminate of these sheets, films, plates, and the like. For example, the carrier 12 may be one that can function as a support having rigidity, such as a glass plate, a ceramic plate, a silicon wafer, or a metal plate, or may be in the form of having no rigidity, such as a metal foil or a resin film. Preferred examples of the metal constituting the carrier 12 include copper, titanium, nickel, stainless steel, and aluminum. Preferred examples of the ceramic include alumina, zirconia, silicon nitride, aluminum nitride, and various other fine ceramics. Preferred examples of the resin include polyethylene terephthalate (PET), polyethylene naphthalate (PEN), polyamides, polyimides, nylons, liquid crystal polymers, polyetheretherketone (PEEK (^{®})), polyamide-imides, polyethersulfone, polyphenylene sulfide, polytetrafluoroethylene (PTFE), and ethylene tetrafluoroethylene (ETFE). More preferably, from the viewpoint of preventing the warpage of a coreless support accompanying heating at the time of mounting a semiconductor device, a material having a coefficient of thermal expansion (CTE) of less than 25 ppm/K (typically 1.0 ppm/K or more and 23 ppm/K or less) is used. Examples of such a material include various resins (particularly low thermal expansion resins such as polyimides and liquid crystal polymers), glass, silicon, and ceramic as described above. From the viewpoint of handleability and ensuring flatness during chip mounting, the carrier 12 preferably has a Vickers hardness of 100 HV or more, and more preferably 150 HV or more and 2500 HV or less. As a material satisfying these characteristics, the carrier 12 is preferably composed of glass, silicon, or ceramic, more preferably glass or ceramic, and particularly preferably glass.

Examples of the carrier 12 composed of glass include a glass plate. When glass is used as the carrier 12, the advantages are that it is lightweight, has a low coefficient of thermal expansion, has high insulating properties, and is rigid and has a flat surface to enable the surface of the metal layer 18 to be extremely smoothed. In addition, when the carrier 12 is glass, the advantages are that it has surface flatness (coplanarity) advantageous for fine circuit formation, and that it has chemical resistance in desmear and various plating steps in a wiring manufacturing process. Preferred examples of the glass constituting the carrier 12 include quartz glass, borosilicate glass, alkali-free glass, soda lime glass, aluminosilicate glass, and combinations thereof, more preferably alkali-free glass, soda lime glass, and combinations thereof, and particularly preferably alkali-free glass. The alkali-free glass is glass containing substantially no alkali metals that is mainly composed of silicon dioxide, aluminum oxide, boron oxide, and alkaline earth metal oxides such as calcium oxide and barium oxide as main components and further contains boric acid. This alkali-free glass has an advantage of having a low and stable coefficient of thermal expansion in the range of 3 ppm/K or more and 5 ppm/K or less in a wide temperature zone of 0°C to 350°C, thus enabling the warpage of the glass in a process involving heating to be minimized. The thickness of the carrier 12 is preferably 100 µm or more and 2000 µm or less, more preferably 300 µm or more and 1800 µm or less, and further preferably 400 µm or more and 1100 µm or less. When the carrier 12 has a thickness within such a range, it is possible to achieve the thinning of wiring and the reduction in warpage that occurs during electronic component mounting, while ensuring suitable strength that does not hinder handling.

The intermediate layer 14, which is optionally provided, is interposed between the carrier 12 and the release layer 16, and serves as a layer that contributes to securing adhesion between the carrier 12 and the release layer 16. Examples of the metal constituting the intermediate layer 14 include Cu, Ti, Al, Nb, Zr, Cr, W, Ta, Co, Ag, Ni, In, Sn, Zn, Ga, Mo, and combinations thereof (hereinafter sometimes referred to as metal M); preferably Cu, Ti, Al, Nb, Zr, Cr, W, Ta, Co, Ag, Ni, Mo, and combinations thereof; more preferably Cu, Ti, Zr, Al, Cr, W, Ni, Mo, and combinations thereof; further preferably Cu, Ti, Al, Cr, Ni, Mo, and combinations thereof; and particularly preferably Cu, Ti, Al, Ni, and combinations thereof. The intermediate layer 14 may be a pure metal or an alloy. The metal constituting the intermediate layer 14 may contain impurities resulting from the raw material component, the film formation step, and the like. Moreover, although not particularly limited, in the case of exposure to the air after the film formation of the intermediate layer 14, the presence of oxygen mixed due to the exposure is allowed. The upper limit of the content of the metal is not particularly limited and may be 100 atomic%. The intermediate layer 14 is preferably a layer formed by a physical vapor deposition (PVD) method, and more preferably a layer formed by sputtering. The intermediate layer 14 is particularly preferably a layer formed by a magnetron sputtering method using a metal target from the viewpoint of uniformity of film thickness distribution. The thickness of the intermediate layer 14 is preferably 10 nm or more and 1000 nm or less, more preferably 30 nm or more and 800 nm or less, further preferably 60 nm or more and 600 nm or less, and particularly preferably 100 nm or more and 400 nm or less. With such a thickness, the intermediate layer can have a roughness equivalent to that of the carrier. This thickness is a value measured by analyzing a layer cross section by a transmission electron microscope-energy dispersive X-ray spectrometer (TEM-EDX).

The intermediate layer 14 may have a one-layer configuration or a configuration of two or more layers. In the case where the intermediate layer 14 has a one-layer configuration, the intermediate layer 14 is preferably composed of a layer containing a metal composed of Cu, Al, Ti, Ni, or a combination thereof (for example, an alloy or an intermetallic compound), more preferably Al, Ti, or a combination thereof (for example, an alloy or an intermetallic compound), and further preferably a layer mainly containing Al or a layer mainly containing Ti. On the other hand, in the case where a metal or an alloy whose adhesion to the carrier 12 cannot be said to be sufficiently high is adopted in the intermediate layer 14, it is preferable that the intermediate layer 14 has a two-layer configuration. That is, by providing a layer composed of a metal (for example, Ti) or an alloy having excellent adhesion to the carrier 12 adjacent to the carrier 12, and by providing a layer composed of a metal (for example, Cu) or an alloy having poor adhesion to the carrier 12 adjacent to the release layer 16, the adhesion to the carrier 12 can be improved. Accordingly, preferred examples of the two-layer configuration of the intermediate layer 14 include a laminated structure composed of a Ti-containing layer adjacent to the carrier 12 and a Cu-containing layer adjacent to the release layer 16. In addition, since the release strength varies depending on the constituent elements and the thickness balance of each layer in the two-layer configuration, it is preferable to adjust the constituent elements and thickness of each layer as appropriate. The scope of "metal M-containing layer" as used herein also encompasses alloys containing elements other than metal M to the extent that the releasability from the carrier is not impaired. Accordingly, the intermediate layer 14 can also be referred to as a layer mainly containing metal M. From the above point, the content of metal M in the intermediate layer 14 is preferably 50 atomic% or more and 100 atomic% or less, more preferably 60 atomic% or more and 100 atomic% or less, further preferably 70 atomic% or more and 100 atomic% or less, particularly preferably 80 atomic% or more and 100 atomic% or less, and most preferably 90 atomic% or more and 100 atomic% or less.

In the case where the intermediate layer 14 is composed of an alloy, preferred examples of the alloy include a Ni alloy. The Ni alloy preferably has a Ni content of 45% by weight or more and 98% by weight or less, more preferably 55% by weight or more and 90% by weight or less, and further preferably 65% by weight or more and 85% by weight or less. The preferred Ni alloy is an alloy of Ni with at least one selected from the group consisting of Cr, W, Ta, Co, Cu, Ti, Zr, Si, C, Nd, Nb, and La, and more preferably an alloy of Ni with at least one selected from the group consisting of Cr, W, Cu, and Si. In the case where the intermediate layer 14 is a Ni alloy layer, it is particularly preferable that the layer is formed by a magnetron sputtering method using a Ni alloy target from the viewpoint of uniformity of film thickness distribution.

The release layer 16 is a layer that enables or facilitates the release of the carrier 12 and, when present, the intermediate layer 14. The release layer 16 may be a layer that can be released using a laser release method (laser lift-off, LLO) in addition to a layer that can be released using a method of physically applying a force. When the release layer 16 is composed of a material that can be released by laser lift-off, the release layer 16 may be composed of a resin with its adhesive strength at the interface reduced by laser beam irradiation after curing, or may be a layer of silicon, silicon carbide, metal oxide, or the like that is modified by laser beam irradiation. The release layer 16 may be either an organic release layer or an inorganic release layer. Examples of the organic component used for the organic release layer include nitrogen-containing organic compounds, sulfur-containing organic compounds, and carboxylic acids. Examples of the nitrogen-containing organic compounds include triazole compounds and imidazole compounds. On the other hand, examples of the inorganic component used for the inorganic release layer include metal oxides or metal oxynitrides including at least one or more of Ni, Mo, Co, Cr, Fe, Ti, W, P, Zn, Cu, Al, Nb, Zr, Ta, Ag, In, Sn, and Ga, or a carbon layer. Among these in particular, the release layer 16 is preferably a carbon-containing layer, that is, a layer mainly containing carbon, in terms of ease of release, film formation properties, and the like, more preferably a layer mainly composed of carbon or a hydrocarbon, and further preferably a layer composed of amorphous carbon, a hard carbon film. In this case, the release layer 16 (that is, a carbon-containing layer) preferably has a carbon concentration of 60 atomic% or more, more preferably 70 atomic% or more, further preferably 80 atomic% or more, and particularly preferably 85 atomic% or more as measured by x-ray photoelectron spectroscopy (XPS). The upper limit value of the carbon concentration is not particularly limited and may be 100 atomic% but is practically 98 atomic% or less. The release layer 16 can contain impurities (for example, oxygen and hydrogen, which are derived from the surrounding environment such as the atmosphere). In the release layer 16, atoms of metals of types other than the metal contained as the release layer 16 can be mixed due to the film formation method of the metal layer 18 or the like. In the case where a carbon-containing layer is used as the release layer 16, the interdiffusivity and reactivity with the carrier are low, and even if the layer is subjected to pressing at a temperature exceeding 300°C, formation of metal bonds due to high-temperature heating between the metal layer and the bonding interface can be prevented to maintain a state where the release and removal of the carrier is easy. This release layer 16 is also preferably a layer formed by a vapor phase method such as sputtering, in terms of suppressing excessive impurities in the release layer 16 and of enabling continuous production with the film formation of the intermediate layer 14, which is optionally provided. In the case where a carbon-containing layer is used as the release layer 16, its thickness is preferably 1 nm or more and 20 nm or less, and more preferably 1 nm or more and 10 nm or less. With such a thickness, the release layer can have a roughness equivalent to that of the carrier and possess a release function. This thickness is a value measured by analyzing a layer cross section by a transmission electron microscope-energy dispersive X-ray spectrometer (TEM-EDX).

The release layer 16 may be a layer including a metal oxide layer and a carbon-containing layer, respectively, or a layer including both a metal oxide and carbon. Particularly, when the carrier-attached metal foil 10 includes the intermediate layer 14, the carbon-containing layer can contribute to the stable release of the carrier 12, and the metal oxide layer can inhibit the diffusion of the metal elements derived from the intermediate layer 14 and the metal layer 18, accompanying heating. As a result, even after the heating at a temperature as high as, for example, 350°C or more, stable releasability can be maintained. The metal oxide layer is preferably a layer including an oxide of metals composed of Cu, Ti, Al, Nb, Zr, Cr, W, Ta, Co, Ag, Ni, In, Sn, Zn, Ga, Mo, or combinations thereof. The metal oxide layer is particularly preferably a layer formed by a reactive sputtering method in which sputtering is performed under an oxidizing atmosphere, using a metal target, in terms of being able to easily control film thickness by the adjustment of film formation time. The thickness of the metal oxide layer is preferably 0.1 nm or more and 100 nm or less. The upper limit value of the thickness of the metal oxide layer is more preferably 60 nm or less, further preferably 30 nm or less, and particularly preferably 10 nm or less. This thickness is a value measured by analyzing a layer cross section by a transmission electron microscope-energy dispersive X-ray spectrometer (TEM-EDX). At this time, the order in which the metal oxide layer and the carbon layer are laminated as the release layer 16 is not particularly limited. The release layer 16 may be present in a state of a mixed phase in which the boundary between the metal oxide layer and the carbon-containing layer is not clearly identified (that is, a layer containing both metal oxide and carbon).

Similarly, from the viewpoint of maintaining stable releasability even after heat treatment at high temperatures, the release layer 16 may be a metal-containing layer in which the surface on the side adjacent to the metal layer 18 is a fluorination-treated surface and/or a nitriding-treated surface. In the metal-containing layer, a region in which the sum of the content of fluorine and the content of nitrogen is 1.0 atomic% or more (hereinafter referred to as a "(F + N) region") is preferably present over a thickness of 10 nm or more, and the (F + N) region is preferably present on the metal layer 18 side of the metal-containing layer. The thickness (in terms of SiO₂) of the (F + N) region is a value specified by performing the depth profile elemental analysis of the carrier-attached metal foil 10 using XPS. The fluorination-treated surface or the nitriding-treated surface can be preferably formed by reactive ion etching (RIE) or a reactive sputtering method. On the other hand, the metal element included in the metal-containing layer preferably has a negative standard electrode potential. Preferred examples of the metal element included in the metal-containing layer include Cu, Ag, Sn, Zn, Ti, Al, Nb, Zr, W, Ta, Mo, and combinations thereof (for example, alloys and intermetallic compounds). The content of the metal element in the metal-containing layer is preferably 50 atomic% or more and 100 atomic% or less. The metal-containing layer may be a single layer composed of one layer or a multilayer composed of two or more layers. The thickness of the entire metal-containing layer is preferably 10 nm or more and 1000 nm or less, more preferably 30 nm or more and 500 nm or less, further preferably 50 nm or more and 400 nm or less, and particularly preferably 100 nm or more and 300 nm or less. The thickness of the metal-containing layer itself is a value measured by analyzing a layer cross section by a transmission electron microscope-energy dispersive X-ray spectrometer (TEM-EDX).

Alternatively, the release layer 16 may be a metal oxynitride-containing layer instead of a carbon layer or the like. The surface of the metal oxynitride-containing layer opposite to the carrier 12 (that is, on the metal layer 18 side) preferably includes at least one metal oxynitride selected from the group consisting of TaON, NiON, TiON, NiWON, and MoON. In terms of ensuring the adhesion between the carrier 12 and the metal layer 18, the surface of the metal oxynitride-containing layer on the carrier 12 side preferably includes at least one selected from the group consisting of Cu, Ti, Ta, Cr, Ni, Al, Mo, Zn, W, TiN, and TaN. Thus, the number of foreign matter particles on the surface of the metal layer 18 is suppressed to improve circuit formation properties, and even after heating at high temperatures for a long time, stable release strength can be maintained. The thickness of the metal oxynitride-containing layer is preferably 5 nm or more and 500 nm or less, more preferably 10 nm or more and 400 nm or less, further preferably 20 nm or more and 200 nm or less, and particularly preferably 30 nm or more and 100 nm or less. This thickness is a value measured by analyzing a layer cross section by a transmission electron microscope-energy dispersive X-ray spectrometer (TEM-EDX).

The metal layer 18 is a layer composed of metal. The metal layer 18 may have a one-layer configuration or a configuration of two or more layers. When the metal layer 18 is composed of two or more layers, the metal layer 18 can have a configuration in which metal layers from a first metal layer to an m-th metal layer (m is an integer of 2 or more) are laminated in order on the surface side of the release layer 16 opposite to the carrier 12. The thickness of the entire metal layer 18 is preferably 1 nm or more and 2000 nm or less, preferably 100 nm or more and 1500 nm or less, more preferably 200 nm or more and 1000 nm or less, further preferably 300 nm or more and 800 nm or less, and particularly preferably 350 nm or more and 500 nm or less. The thickness of the metal layer 18 is a value measured by analyzing a layer cross section by a transmission electron microscope-energy dispersive X-ray spectrometer (TEM-EDX). An example in which the metal layer 18 is composed of two layers, a first metal layer and a second metal layer, will be described below.

The first metal layer preferably provides the desired functions such as an etching stopper function and an antireflection function to the carrier-attached metal foil. Preferred examples of the metal constituting the first metal layer include Ti, Al, Nb, Zr, Cr, W, Ta, Co, Ag, Ni, Mo, and combinations thereof, more preferably Ti, Zr, Al, Cr, W, Ni, Mo, and combinations thereof, further preferably Ti, Al, Cr, Ni, Mo, and combinations thereof, and particularly preferably Ti, Mo, and combinations thereof. These elements have the property of being less likely to dissolve in flash etchants (for example, copper flash etchants) and, as a result, can exhibit excellent chemical resistance to flash etchants. Therefore, the first metal layer is a layer less likely to be etched with a flash etchant than the second metal layer to be described later, and can thus function as an etching stopper layer capable of delaying progression of etching. In addition, the metal constituting the first metal layer described above also has the function of preventing the reflection of light, and hence the first metal layer can also function as an antireflection layer for improving visibility in image inspection (for example, automatic image inspection (AOI)). The first metal layer may be a pure metal or an alloy. The metal constituting the first metal layer may contain impurities resulting from the raw material component, the film formation step, and the like. The upper limit of the content of the metal is not particularly limited and may be 100 atomic%. The first metal layer is preferably a layer formed by a physical vapor deposition (PVD) method, and more preferably a layer formed by sputtering. The thickness of the first metal layer is preferably 1 nm or more and 500 nm or less, more preferably 10 nm or more and 400 nm or less, further preferably 30 nm or more and 300 nm or less, and particularly preferably 50 nm or more and 200 nm or less.

Preferred examples of the metal constituting the second metal layer include the transition elements of groups 4, 5, 6, 9, 10, and 11, Al, and combinations thereof (for example, alloys and intermetallic compounds), more preferably the transition elements of groups 4 and 11, Al, Nb, Co, Ni, Mo, and combinations thereof, further preferably the transition elements of group 11, Ti, Al, Mo, and combinations thereof, particularly preferably Cu, Ti, Mo, and combinations thereof, and most preferably Cu. The second metal layer may be manufactured by any method and may be a metal foil formed by, for example, wet film formation methods such as an electroless metal plating method and an electrolytic metal plating method, physical vapor deposition (PVD) methods such as sputtering and vacuum deposition, chemical vapor film formation, or combinations thereof. A particularly preferred second metal layer is a metal layer formed by physical vapor deposition (PVD) methods such as a sputtering method and vacuum deposition, most preferably a metal layer manufactured by a sputtering method, from the viewpoint of being easily adapted to a fine pitch due to superthinning. The second metal layer is preferably a metal layer without roughening treatment, but may be one in which secondary roughening is performed by preliminary roughening, soft etching treatment, rinse treatment, or oxidation-reduction treatment, as long as wiring pattern formation is not hindered. From the viewpoint of being adapted to a fine pitch, the thickness of the second metal layer is preferably 10 nm or more and 1000 nm or less, more preferably 20 nm or more and 900 nm or less, further preferably 30 nm or more and 700 nm or less, further more preferably 50 nm or more and 600 nm or less, particularly preferably 70 nm or more and 500 nm or less, and most preferably 100 nm or more and 400 nm or less. The metal layer having a thickness within such a range is preferably manufactured by a sputtering method from the viewpoint of the in-plane uniformity of film formation thickness, and productivity in a sheet form or a roll form.

When the metal layer 18 has a one-layer configuration, the second metal layer described above is preferably adopted as it is as the metal layer 18. On the other hand, when the metal layer 18 has an n-layer (n is an integer of 3 or more) configuration, the metal layers from the first to the (n-1)th in the metal layer 18 preferably have the configuration of the first metal layer described above, and the outermost layer, that is, the n-th metal layer, in the metal layer 18 preferably has the configuration of the second metal layer described above.

The intermediate layer 14 (if present), the release layer 16, and the metal layer 18 are preferably all physical vapor deposition (PVD) films, that is, films formed by a physical vapor deposition (PVD) method, and more preferably sputter films, that is, films formed by a sputtering method.

The end face of the carrier 12 is preferably covered by the extension of the metal layer 18, optionally the intermediate layer 14, and optionally the release layer 16 (that is, at least the metal layer 18, for example, the metal layer 18 and the intermediate layer 14) to the end face. That is, not only the surface but also the end face of the carrier 12 is preferably covered with at least the metal layer 18. By covering the end face as well, it is possible to prevent the infiltration of chemical liquids into the carrier 12 in the wiring substrate manufacturing process, and also to strongly prevent chipping due to release at the side end when the carrier-attached metal foil 10 is handled, that is, chipping of the film on the release layer 16 (that is, the metal layer 18). The covered region on the end face of the carrier 12 is preferably a region 0.1 mm or more and more preferably 0.2 mm or more from the surface of the carrier 12 toward the thickness direction (that is, the direction perpendicular to the carrier surface), and is further preferably throughout the end face of the carrier 12.

The thickness of the entire carrier-attached metal foil 10 is not particularly limited, but is preferably 500 µm or more and 3000 µm or less, more preferably 700 µm or more and 2500 µm or less, further preferably 900 µm or more and 2000 µm or less, and particularly preferably 1000 µm or more and 1700 µm or less. The size of the carrier-attached metal foil 10 is not particularly limited, but is preferably a diameter of 10 cm or more or 10 cm square or more, more preferably a diameter of 20 cm or more or 20 cm square or more, and further preferably a diameter of 25 cm or more or 25 cm square or more. The upper limit of the size of the carrier-attached metal foil 10 is not particularly limited, but a diameter of 1000 cm or 1000 cm square can be cited as one reference. In addition, the carrier-attached metal foil 10 is in a form that can be handled individually by itself before and after formation of the resin-containing layer 22.

### Laminate

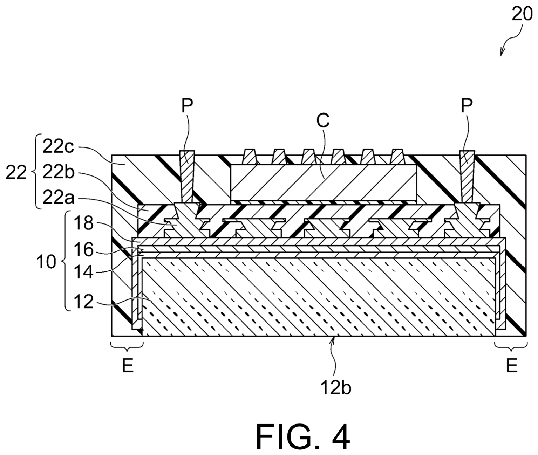

According to a preferred aspect of the present invention, there is provided a laminate including the carrier-attached metal foil 10. An example of the laminate of the present invention is illustrated in Figure 4. As shown in Figure 4, a laminate 20 includes the carrier-attached metal foil 10 and a resin-containing layer 22 provided on the metal layer 18 of the carrier-attached metal foil 10. The resin-containing layer 22 preferably includes a wiring layer 22a, an insulating layer 22b, and/or a mold resin layer 22c. More preferably, as shown in Figure 4, the resin-containing layer 22 includes the insulating layer 22b and the wiring layer 22a formed inside and/or on the surface of the insulating layer 22b, and further includes the mold resin layer 22c that covers or embeds the wiring layer 22a, the insulating layer 22b, and the carrier-attached metal foil 10. The resin-containing layer 22 (for example, the insulating layer 22b and/or the mold resin layer 22c) preferably contains an insulating resin. Examples of such an insulating resin include an epoxy resin and a phenolic resin.

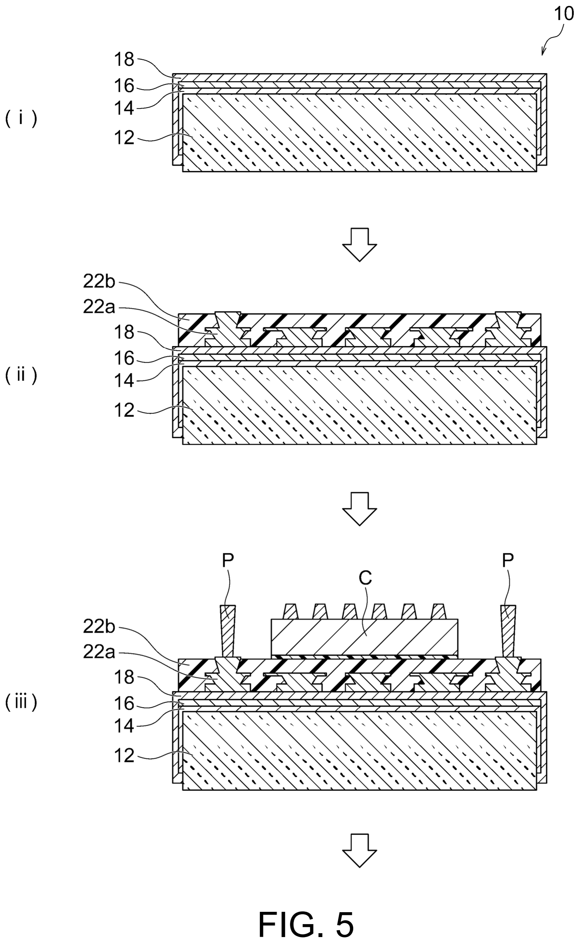

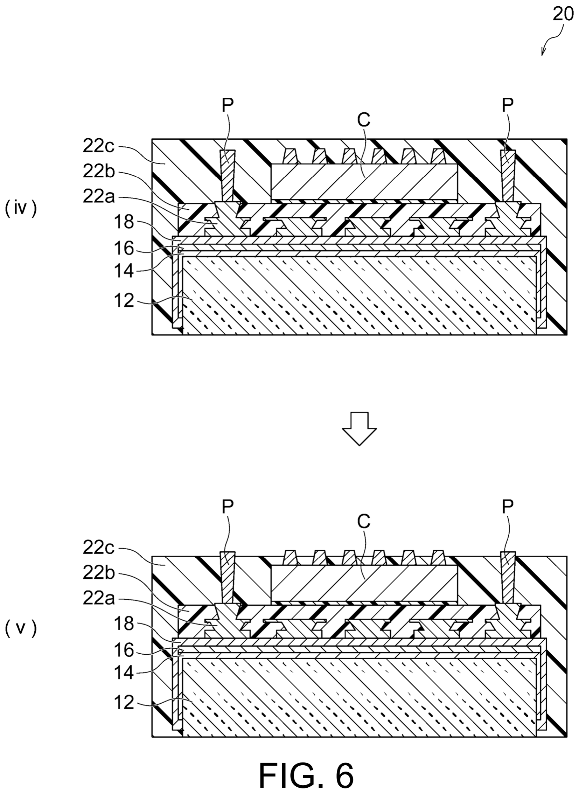

The laminate 20 can be preferably prepared by, for example, the steps shown in Figures 5 and 6. First, the carrier-attached metal foil 10 described above is provided (Figure 5(i)), and the wiring layer 22a and the insulating layer 22b are formed on the surface of the metal layer 18 (Figure 5(ii)). The formation of the wiring layer 22a and the insulating layer 22b should be carried out by a known method, and for example, the coreless build-up method described above can be preferably adopted. Also, if necessary, a pillar (columnar electrode) P may be formed or a chip C may be mounted on the wiring layer 22a and/or the insulating layer 22b (Figure 5(iii)). Thereafter, mold forming is carried out so that the mold resin layer 22c covers or embeds at least a part of the side surface of the carrier-attached metal foil 10 (preferably the entire carrier-attached metal foil 10 other than the second surface 12b), as well as the wiring layer 22a and the insulating layer 22b, thereby obtaining the laminate 20 (Figure 6(iv)). Optionally, the upper surface of the mold resin layer 22c may be subjected to grinding and/or chemical mechanical polishing (CMP) so as to expose the pillar P and the like from the mold resin layer 22c (Figure 6(v)). In addition, the size of the laminate 20 may be adjusted by cutting the side surface of the mold resin layer 22c.

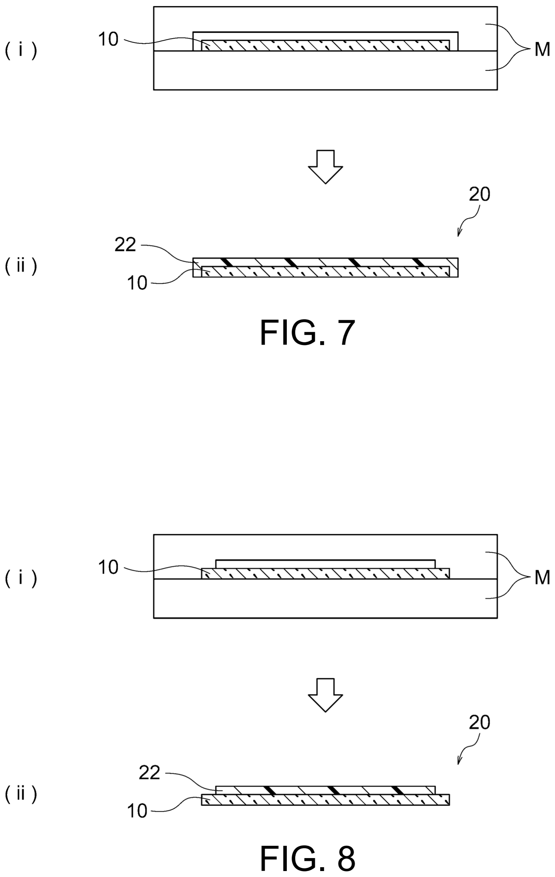

The resin-containing layer 22 (for example, the mold resin layer 22c) preferably covers at least a part of the side surface of the carrier-attached metal foil 10, thereby having an extending portion E extending outward beyond the end surface of the carrier 12. More preferably, as shown in Figure 4, the resin-containing layer 22 (for example, the mold resin layer 22c) embeds the entire carrier-attached metal foil 10 other than the second surface 12b. The laminate 20 of the present aspect can be said to be a resultant product of full mold forming carried out on the carrier-attached metal foil 10. Here, Figures 7 and 8 respectively show examples of preparing a laminate having a full mold structure and a laminate having a flange mold structure using a mold. In this regard, the laminate 20 having a full mold structure as shown in Figure 7(ii) has an advantage that destruction of the carrier and the like is suppressed and yield is improved, compared with the laminate 20 having a flange mold structure shown in Figure 8(ii). That is, as shown in Figure 8(i), the mold M for carrying out flange mold forming has a space for forming a mold resin layer only on one surface side of the carrier-attached metal foil 10. Therefore, resin residues accumulate in that space, and a local force due to the resin residues is likely to be applied to the surface of the carrier-attached metal foil 10 during compression forming. As a result, destruction of the carrier and the like is likely to occur. In contrast, as shown in Figure 7(i), the mold M for carrying out full mold forming has spaces not only on the upper surface but also on the side surface of the carrier-attached metal foil 10, and therefore, a local force due to the resin residues is less likely to be applied to the surface of the carrier-attached metal foil 10. As a result, it is considered that destruction of the carrier and the like is less likely to occur.

Meanwhile, the laminate 20 having a full mold structure has a larger size than that of the carrier-attached metal foil 10 since the resin-containing layer 22 covers at least a part of the side surface of the carrier-attached metal foil 10, and the resin-containing layer 22 preferably embeds the entire carrier-attached metal foil 10 other than the second surface 12b. Therefore, a problem may occur in that the size of the laminate 20 deviates from the apparatus standard, which makes it impossible to proceed to the step of forming a redistribution layer on the resin-containing layer 22, which is a step after mold forming. In this regard, according to the laminate 20, since misalignment from the center position of the carrier and angular misalignment can be accurately detected based on the alignment mark AM provided on the second surface 12b of the carrier, downsizing of the laminate 20 can be appropriately carried out by appropriately setting the laminate 20 in a cutting apparatus based thereon. The length of the extending portion E separated outward from the end surface of the carrier after downsizing is preferably 1.0 mm or less, more preferably 0.5 mm or less, further preferably 0.3 mm or less, and particularly preferably 0.1 mm or less. Optionally, the length may be -0.1 mm or less, that is, the extending portion E may be completely cut off, and furthermore, the carrier 12 may also be cut.

### Method for Manufacturing Wiring Board

According to another preferred aspect of the present invention, there is provided a method for manufacturing a wiring board using the carrier-attached metal foil 10. This method includes the steps of (1) providing a carrier-attached metal foil, (2) forming a resin-containing layer, (3) cutting off an extending portion of the resin-containing layer, and (4) optionally forming a redistribution layer. Each of the steps (1) to (4) will be described below with reference to the drawings.

### (1) Providing Carrier-Attached Metal Foil

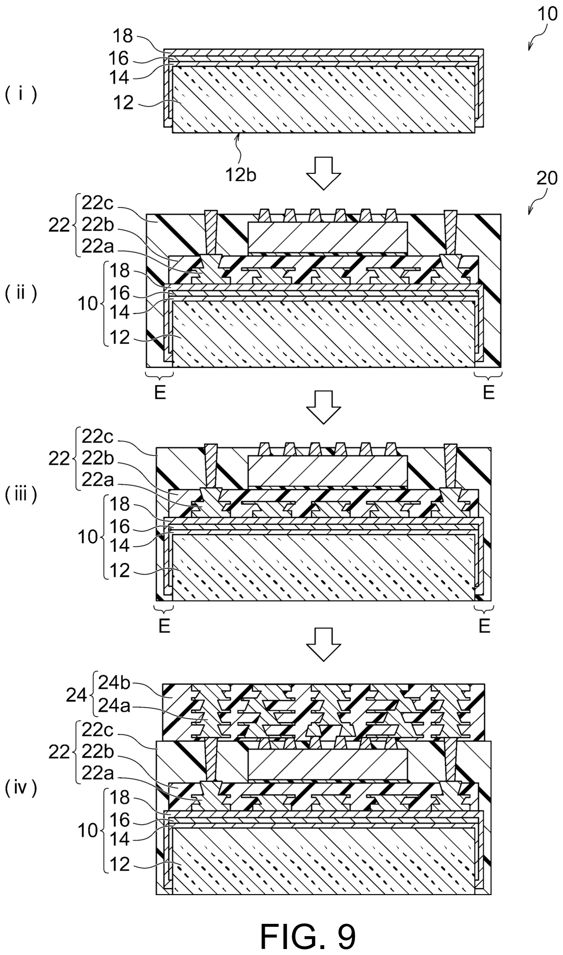

A carrier-attached metal foil 10 including an optionally provided intermediate layer 14 (that is, an optional layer), a release layer 16, and a metal layer 18 on one surface of a carrier 12 (that is, a first surface 12a) is provided (Figure 9(i)). The carrier-attached metal foil 10 has at least one alignment mark AM on a second surface 12b of the carrier. Other preferred aspects of the carrier-attached metal foil 10 are as described above.

Formation of the alignment mark AM is preferably performed on the second surface 12b of the carrier by laser printing, laser engraving, gravure printing, flexographic printing, ink jet printing, silk printing, laser inner marking, drilling, or a combination thereof, more preferably by laser inner marking, laser engraving, or a combination thereof, and further preferably by laser inner marking.

Formation of each layer of the intermediate layer 14 (if present), the release layer 16, and the metal layer 18 is preferably carried out by a physical vapor deposition (PVD) method from the viewpoint of being easily adapted to a fine pitch due to superthinning. Examples of the physical vapor deposition (PVD) method include sputtering, vacuum deposition, and ion plating, but in terms of being able to control film thickness over a wide range, such as 0.05 nm or more and 5000 nm or less and of being able to ensure film thickness uniformity over a wide width or area, sputtering is most preferable. In particular, forming all layers of the intermediate layer 14 (if present), the release layer 16, and the metal layer 18 by the sputtering method significantly improves manufacturing efficiency.

Film formation by the physical vapor deposition (PVD) method may be carried out using a known vapor deposition apparatus under known conditions, and is not particularly limited. For example, in the case of adopting a sputtering method, the sputtering technique may be any of various known methods such as magnetron sputtering, bipolar sputtering, and facing target sputtering, with magnetron sputtering being preferable in terms of its high film formation rate and productivity. Sputtering may be carried out using either a DC (direct current) or RF (radio frequency) power source. As for the target shape, a widely known plate-type target may be used; however, from the viewpoint of target use efficiency, it is desirable to use a cylindrical target. The purity of the target is preferably 99.9% or more. As the gas for sputtering, it is preferable to use an inert gas such as argon gas. The flow rate of argon gas may be determined as appropriate depending on the sputtering chamber size and film formation conditions, and is not particularly limited. In addition, from the viewpoint of performing continuous film formation without operational failures such as abnormal discharge or poor plasma irradiation, it is preferable that the pressure during film formation is in the range of 0.1 Pa or more and 20 Pa or less. This pressure range may be set by adjusting the film formation power and the flow rate of argon gas depending on the apparatus structure, capacity, vacuum pump exhaust capacity, rated capacity of the film formation power source, and the like. In addition, the sputtering power may be set as appropriate in the range of 0.05 W/cm² or more and 10.0 W/cm² or less per unit area of the target in consideration of film thickness uniformity, productivity, and other factors for film formation.

### (2) Forming Resin-Containing Layer

A resin-containing layer 22 is formed on the metal layer 18 of the carrier-attached metal foil 10 to obtain a laminate 20 (Figure 9(ii)). The formation of the resin-containing layer 22 is carried out so as to cover at least a part of the side surface of the carrier-attached metal foil 10, thereby having an extending portion E extending outward beyond the end surface of the carrier 12. Preferably, the resin-containing layer 22 is formed so as to embed the entire carrier-attached metal foil 10 other than the second surface 12b.

The resin-containing layer 22 preferably includes a wiring layer 22a and an insulating layer 22b as described above with reference to Figures 5 and 6 regarding the laminate 20, and more preferably further includes a mold resin layer 22c that covers or embeds the wiring layer 22a, the insulating layer 22b, and the carrier-attached metal foil 10. For example, the wiring layer 22a and the insulating layer 22b may be formed on the surface of the metal layer 18 by a coreless build-up method (Figure 5(ii)). Specifically, a photoresist is laminated onto the metal layer 18, exposed and developed to form a predetermined pattern, thereby forming a resist pattern. Prior to this exposure, positional alignment using the alignment mark AM provided on the second surface 12b of the carrier may be carried out. Then, electroplating (for example, copper electroplating) is performed in the spaces of the resist pattern, and after removing the resist pattern, unnecessary portions of the metal layer 18 exposed by the resist pattern removal (that is, portions where no wiring pattern is formed) are removed by etching to form a first wiring layer. Thereafter, on the surface of the carrier-attached metal foil 10 where the first wiring layer has been formed, an insulating layer and an n-th wiring layer (n is an integer of 2 or more) are alternately formed. In this way, a layer including the insulating layer and the wiring layer formed inside and/or on the surface of the insulating layer (that is, a redistribution layer) is obtained. Optionally, a pillar P may be formed or a chip C may be mounted on the wiring layer 22a and/or the insulating layer 22b (Figure 5(iii)). Thereafter, forming of the mold resin layer 22c is carried out so as to cover or embed at least a part of the side surface of the carrier-attached metal foil 10 (preferably the entire carrier-attached metal foil 10 other than the second surface 12b), as well as the wiring layer 22a and the insulating layer 22b, thereby preferably obtaining the laminate 20 (Figure 6(iv)).

Prior to the formation of the redistribution layer described later, it is preferable to further include a step of polishing the surface of the resin-containing layer 22 (for example, the mold resin layer 22c). Preferred examples of surface polishing include grinding using a grindstone and chemical mechanical polishing (CMP). For example, by polishing the upper surface of the mold resin layer 22c, the pillar P and the like may be exposed from the mold resin layer 22c as shown in Figure 6(v). Polishing of the resin-containing layer 22 may be carried out before cutting off the extending portion E described later, or may be carried out after cutting off the extending portion E.

### (3) Cutting off Extending Portion of Resin-Containing Layer

Positioning is carried out based on the alignment mark AM provided on the second surface 12b of the carrier, and at least a part of the extending portion E is cut off (Figure 9(iii)). In this way, the laminate 20 can be downsized so as to have a size corresponding to the standard of the apparatus with which formation of the redistribution layer described later is carried out.

As described above, since the carrier-attached metal foil 10 has the alignment mark AM provided on the surface on the opposite side to the metal layer 18 of the carrier 12 (that is, the second surface 12b), even after the entire carrier-attached metal foil 10 other than the second surface 12b is embedded in the resin-containing layer 22, the alignment mark AM can be identified from the second surface 12b side. Therefore, based on the alignment mark AM, positional alignment of the laminate 20 after formation of the resin-containing layer 22 can be accurately carried out. As a result, even in the case where positional misalignment occurs during mold forming, the extending portion E can be cut off with the intended width.

Cutting-off of the extending portion E is preferably carried out so that, when the carrier-attached metal foil 10 after formation of the resin-containing layer 22 is seen in a plan view, the extending width of the portion extending from the end surface of the carrier 12 in the resin-containing layer 22 is 1.0 mm or less, more preferably 0.5 mm or less, further preferably 0.3 mm or less, particularly preferably 0.2 mm or less, and most preferably 0.1 mm or less. The method for cutting off the extending portion E is not particularly limited, and can be carried out by, for example, using a cutting tool such as a cutter or a machine tool such as a cutting blade. Alternatively, by using the cutting apparatus described later, cutting-off of the extending portion E can be preferably carried out.

### (4) Forming Redistribution Layer (Optional Step)

Optionally, a redistribution layer 24 is formed on the surface of the resin-containing layer 22 (Figure 9(iv)). In the present invention, the redistribution layer refers to a layer including an insulating layer and a wiring layer formed inside and/or on the surface of the insulating layer. For example, by forming a wiring layer 24a and an insulating layer 24b by the coreless build-up method described above, the redistribution layer 24 can be obtained.

After formation of the redistribution layer 24, steps such as mounting electronic elements, such as chips, on the redistribution layer 24 may be further carried out to form a wiring board. Together with the chip C that may be embedded in the resin-containing layer 22 described above, a plurality of IC packages can be stacked and mounted on the substrate to improve the degree of integration. In addition, the carrier 12, the intermediate layer 14 (if present), the release layer 16, and the metal layer 18 may be removed by a known method.

Examples of the electronic elements assumed to be mounted on the redistribution layer 24 in the optional step include semiconductor elements, chip capacitors, and resistors. Examples of the method for mounting electronic elements include a flip chip mounting method and a die bonding method. The flip chip mounting method is a method in which mounting pads of the electronic elements are bonded to the redistribution layer. On these mounting pads, pillars, solder bumps, or the like may be formed, and prior to mounting, a sealing resin film such as a non-conductive film (NCF) may be adhered to the surface of the redistribution layer. The bonding is preferably carried out using a low-melting-point metal such as solder, but an anisotropic conductive film or the like may also be used. The die-bonding adhesive method is a method in which the surface on the opposite side to the mounting pad surface of the electronic elements is adhered to the redistribution layer. For this adhesion, it is preferable to use a paste or film that is a resin composition containing a thermosetting resin and a thermally conductive inorganic filler.

### Cutting Apparatus

According to another preferred aspect of the present invention, there is provided a cutting apparatus for downsizing the laminate 20. This cutting apparatus is assumed to be used in the step of cutting off the extending portion E of the resin-containing layer 22 in the above-described method for manufacturing a wiring board, for example. The cutting apparatus includes a fixing unit, an identifying unit, and a cutting-off unit. The fixing unit supports and fixes the laminate 20. The means for fixing the laminate 20 by the fixing unit is not particularly limited and may be any means. For example, the fixing unit may include a stage on which the laminate 20 can be placed and a suction means (for example, a vacuum pump) capable of suctioning the laminate 20 toward the stage via a suction hole provided in the stage. The stage may be a known alignment stage capable of moving the laminate 20 in the horizontal direction and the rotational direction, whereby the laminate 20 whose positional misalignment has been detected can be moved to the correct position. The fixing unit may support and fix the second surface 12b side of the carrier in the laminate 20, or may support and fix the side opposite to the second surface 12b of the carrier. Alternatively, the fixing unit may fix the side surface portion of the laminate 20. In the case where the fixing unit fixes the second surface 12b side of the carrier, it is preferable that the stage is composed of a material having optical transparency, for example, so that the identifying unit can recognize the alignment mark AM. The identifying unit recognizes the alignment mark AM from the second surface 12b side of the carrier with respect to the laminate 20 fixed by the fixing unit to specify positional information of the laminate 20. The identifying unit may be a known positioning means such as an image processing system. For example, the identifying unit may include an imaging means (for example, a CCD camera) capable of imaging the second surface 12b side of the carrier, and a pattern matching means for recognizing the alignment mark AM from the captured image data. The cutting-off unit cuts off the side surface of the laminate 20 (for example, the extending portion E of the resin-containing layer 22) whose positional information has been specified by the identifying unit. The cutting-off unit may include a cutting means such as a rotary blade and a moving means for moving the cutting means in the vertical direction and/or horizontal direction. For example, based on the positional information of the laminate 20, the cutting-off unit may cut off unnecessary portions while the rotary blade or the like moves along the side surface (that is, the cutting section) of the laminate 20 via the moving means. In order to carry out the above operations, it is preferable that the cutting apparatus further includes a control means for controlling the fixing unit, the identifying unit, and/or the cutting-off unit.

## Claims

1. A carrier-attached metal foil comprising a carrier having a first surface and a second surface, a release layer provided on the first surface, and a metal layer provided on the release layer,
wherein the carrier-attached metal foil has at least one alignment mark on or in a vicinity of the second surface of the carrier.

2. The carrier-attached metal foil according to claim 1, wherein the alignment mark has a shape capable of acquiring positional information in a horizontal direction and a rotational direction on the second surface of the carrier.

3. The carrier-attached metal foil according to claim 1 or 2, wherein at least one of the alignment marks is positioned at a geometric center on the second surface of the carrier.

4. The carrier-attached metal foil according to claim 1 or 2, wherein the alignment mark has at least one shape selected from the group consisting of a cross, a polygon, a star-shaped polygon, a circle, an ellipse, a character, and a symbol.

5. The carrier-attached metal foil according to claim 1 or 2, wherein the carrier is composed of at least one selected from the group consisting of glass, silicon, ceramic, resin, and metal.

6. The carrier-attached metal foil according to claim 1 or 2, wherein the alignment mark is formed by at least one selected from the group consisting of laser printing, laser engraving, gravure printing, flexographic printing, ink jet printing, silk printing, laser inner marking, and drilling.

7. A laminate comprising the carrier-attached metal foil according to claim 1 or 2 and a resin-containing layer provided on the metal layer.

8. The laminate according to claim 7, wherein the resin-containing layer covers at least a part of a side surface of the carrier-attached metal foil, thereby having an extending portion extending outward beyond an end surface of the carrier.

9. The laminate according to claim 8, wherein the resin-containing layer embeds an entirety of the carrier-attached metal foil except for the second surface.

10. The laminate according to claim 7, wherein the resin-containing layer comprises an insulating resin.

11. A method for manufacturing a wiring board, comprising the steps of:
providing the carrier-attached metal foil according to claim 1 or 2;
forming a resin-containing layer on the metal layer of the carrier-attached metal foil so that the resin-containing layer covers at least a part of a side surface of the carrier-attached metal foil, thereby having an extending portion extending outward beyond an end surface of the carrier; and
carrying out positioning based on the alignment mark provided on the second surface of the carrier and cutting off at least a part of the extending portion.

12. The method for manufacturing a wiring board according to claim 11, wherein cutting-off of the extending portion is carried out so that, when the carrier-attached metal foil with the resin-containing layer formed thereon is seen in a plan view, an extending width of a portion of the resin-containing layer extending from an end surface of the carrier is 1.0 mm or less.

13. The method for manufacturing a wiring board according to claim 11, further comprising a step of forming a redistribution layer on a surface of the resin-containing layer after cutting off at least a part of the extending portion.

14. The method for manufacturing a wiring board according to claim 13, further comprising a step of polishing a surface of the resin-containing layer before forming the redistribution layer.

15. The method for manufacturing a wiring board according to claim 11, wherein the resin-containing layer comprises a wiring layer and an insulating layer.

16. A cutting apparatus for downsizing the laminate according to claim 8, the cutting apparatus comprising:
a fixing unit that fixes the laminate;
an identifying unit that recognizes the alignment mark from a second surface side of the carrier with respect to the laminate fixed by the fixing unit to specify positional information of the laminate; and
a cutting-off unit that cuts off a side surface of the laminate whose positional information has been specified by the identifying unit.
